(19) **Europäisches Patentamt**

**European Patent Office**

**Office européen des brevets**

(11) **EP 0 750 401 A2**

(12) **EUROPEAN PATENT APPLICATION**

(43) Date of publication:
27.12.1996 Bulletin 1996/52

(51) Int. Cl.$^6$: **H03M 13/12**, H04L 1/00,
G06F 11/10

(21) Application number: 96109957.9

(22) Date of filing: 20.06.1996

(84) Designated Contracting States:
**DE FI FR SE**

(30) Priority: **24.06.1995 GB 9512944**

(71) Applicant: **MOTOROLA LTD**
**Basingstoke, Hampshire RG22 4PD (GB)**

(72) Inventors:
• **Bennett, Irwin**
**Swindon, Wiltshire SN1 4DR (GB)**
• **Golding, Paul**
**Swindon, Wiltshire SN2 2TZ (GB)**

• **King, Barry**
**Swindon, Wiltshire SN5 6BE (GB)**
• **Page, Andrew**
**Swindon, Wiltshire SN1 9TW (GB)**

(74) Representative: **Spaulding, Sarah Jane et al**
**Motorola,**
**European Intellectual Property Operations,**
**Midpoint,**
**Alencon Link**
**Basingstoke, Hampshire RG21 7PL (GB)**

(54) **Convolutional coder**

(57) A convolutional coder (10) for generating a convolutional code (14) is arranged to reduce to a minimum the number of processing steps required in a processor, such as a DSP, to achieve a cyclic redundancy coding function. The convolutional coder (10) comprises a shift register (12) having a plurality of storage elements each for storing a data bit. First (20) and second (22) tap registers each store a tap position indicator indicative of tap positions in the shift register that are subject to a logical operation. an input (17) shifts input data into the convolutional coder (10). A logic network (11), coupled to receive the input data and arranged to provide the logical operation, has first (g0) and second (g1) outputs for providing, respectively, first and second output data bits that form the convolutional code (14); The first output data bit is generated in response to the input data and the logical combination of each data bit stored in each storage element identified by the first tap position indicator and the second output data bit is generated in response to the input data and the logical combination of each data bit stored in each storage element identified by the second tap position indicator.

FIG.3

EP 0 750 401 A2

## Description

### Background of the Invention

This invention relates, in general, to convolutional coders and is particularly, but not exclusively, applicable to convolutional coders utilised with digital signal processors (DSPs).

### Summary of the Prior Art

Infrastructure of modem communications systems, such as the pan-European GSM (Groupe Speciale Mobile) cellular communications system, is required to undertake and successfully execute a multitude of complex tasks. For example, the infrastructure is required to administer such tasks as communication hand-off between discrete cells of the communication system, and also the encryption or decryption of information (either voice or data) that is transmitted over a communication resource of the system.

In general, the number of components in a base station, for example, required to realise a particular function offered by that base station is related to the intensity of the tasks performed to execute that function, and the processing capability of the components on which the function is performed. However, as a consequence of the ever-increasing competition in the market-place for communications systems, manufacturers in general have found it necessary to produce low cost, reliable equipment that can cope with the ever increasing demands of system operation and functionality. In this respect, manufacturers have attempted to reduce to a minimum the number of components, such as DSPs, and to optimise the use of these components.

Clearly, increasing the speed of operation of components results in an increase in the processing (handling) capacity of each component and hence an increased throughput, which increased throughput may permit elimination of some components. Also, in combination with the development of faster components, manufacturers have reduced component count by developing dedicated, integrated circuits that perform specific functions as efficiently as possible. However, in this latter case, manufacturers have experienced that such development is both costly in time and money and can often lead to a structural solution that is inflexible and therefore difficult to adapt to future needs. As such, development of dedicated integrated circuits is only really acceptable when the requirements of the system are known, understood or stable. Furthermore, although the increase in processing power ultimately provides a cheaper and more flexible solution, current technologies (such as DSP technology) have placed an upper limit on component (device) speed that is insufficient to meet the present-day requirements and aspirations of manufacturers.

One particular function that requires extensive processing power, i.e. the extensive use of DSPs, arises from the convolutional coding requirements of inter alia the aforementioned GSM communication system. More specifically, these convolutional codes are used to enhance error detection and correction of control channel information, data traffic information and speech traffic channel information in a channel coder of a Base Transceiver Station (BTS), for example. In the case of a convolutional coder for GSM half-rate speech traffic channels, convolutional codes are defined (in GSM Technical Specification 05.03) by a polynomial expression of the form:

$$g0(D) = D^0 + D^2 + D^3 + D^5 + D^6$$

$$g1(D) = D^0 + D^1 + D^4 + D^6$$

$$g0(D) = D^0 + D^1 + D^2 + D^3 + D^4 + D^6.$$

In this exemplary case, the convolutional coder has a "rate" (i.e. the number of output bits per input bit) of 1/3 and a "constraint length" (i.e. generally defined as the sum of the number of stages and the input) of 7.

Although this polynomial expression currently defines a convolutional code, there is a likelihood that this code will be modified (or further new codes developed) to improve speech quality provided by the GSM channel coder unit. Therefore, since these additional convolutional codes are yet to be defined, the potential inflexibility imposed through the use of dedicated integrated circuits on future adaptations of existing infrastructure deters the use of such dedicated circuits.

As such, there is a requirement to provide a method of increasing the efficiency of a DSP in performing convolutional coding, for example, in such a way that the number of calls that can be handled by the DSP is increased while, at the same time, ensuring that there is sufficient flexibility in the DSP structure or architecture to allow the DSP to be modified to accommodate new convolutional codes and therefore to extend the life of the equipment, e.g. infrastructure.

### Summary of the Invention

According to the present invention there is provided a convolutional coder for generating a convolutional code, comprising: a shift register having a plurality of storage elements each for storing a data bit; first and second tap registers, each for storing a tap position indicator indicative of tap positions in the shift register that are subject to a logical operation; an input for shifting input data into the convolutional coder; and a logic network, coupled to receive the input data and arranged to provide the logical operation, having first and second outputs for providing, respectively, first and second output data bits that form the convolutional code; wherein the first output data bit is generated in response to the input data and the logical combination of each data bit stored in each storage element identified by the first tap position indicator; and the second output data bit is generated in response to the input data and the logical combination of each data bit stored in each storage element identified by the second tap position indicator.

An exemplary embodiments of the present invention will now be described with reference to the accompanying drawings.

Brief Description of the Drawings

FIG. 1 is a representation of a convolutional code function implemented by the present invention.

FIG. 2 is a register configuration of a preferred embodiment of the present invention.

FIG. 3 illustrates a logical combination of corresponding bits of the registers of FIG. 2.

FIG. 4 illustrates a block diagram of the general concepts of the present invention.

Detailed Description of a Preferred Embodiment

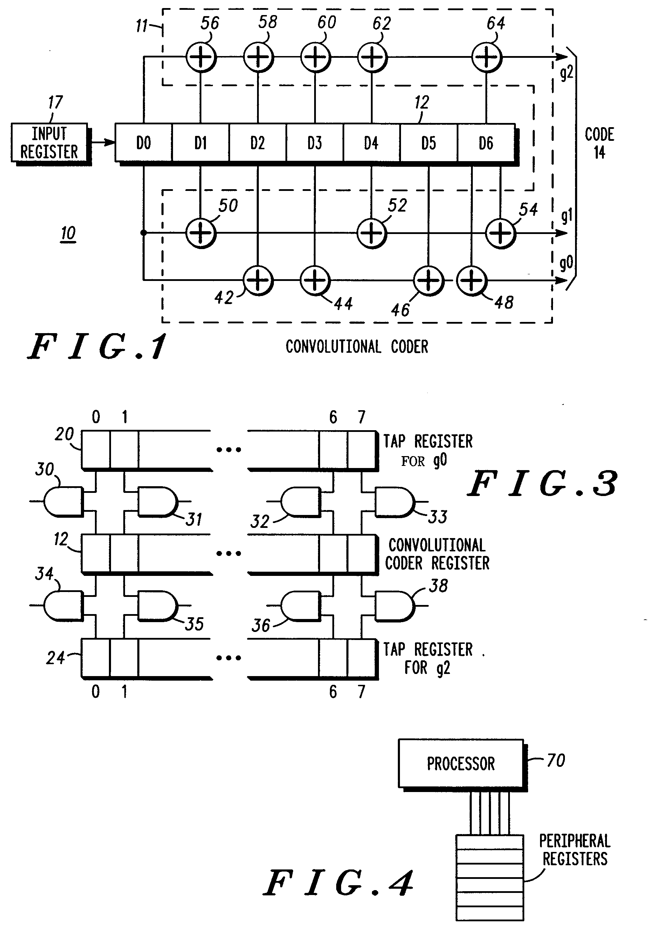

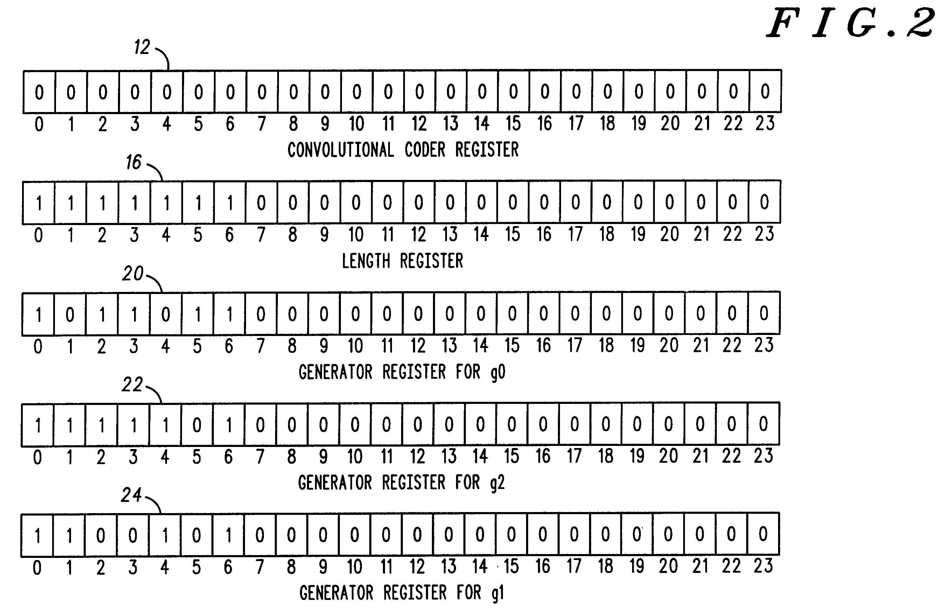

FIGs. 1 and 2 represent, in combination, a convolutional coder and its function, generally depicted 10, implemented by the present invention. A convolutional coder register 12 is arranged to store a plurality of data bits on which a logical operation is subsequently performed (by a logic network 11 out-lined in hatch) to produce, ultimately, a convolutional code 14 (g0-g2) according to a predetermined polynomial expression (such as the convolutional code for GSM half-rate speech traffic channels identified above). In the case of FIG. 1, the convolutional coder register 12, which is basically a shift register, contains twenty-four storage elements (0 to 23) each capable of storing a data bit.

As will be appreciated, the length of the convolutional coder register 12 is somewhat arbitrary because it need only be sufficient to store a number of data bits required to generate the polynomial that satisfies the requirements of a convolutional code calculation. In this respect, a length register 16 is provided to set the requisite length of the convolutional coder register 12. More specifically, consecutive storage elements of the length register 16 are set to a common logical value (in this case logical "1") to indicate the length of the data bits of interest in the convolutional coder register 12. As can be seen, the length register 16 has bits 0 to 6 set to logical 1, thereby defining the number of bits of interest in the convolutional coder register 12 as being seven bits in length. By providing a length register 16, the length of the convolutional coder register 12 may be altered according to the requirements of any convolutional code by simply re-programming the length register 16 with an appropriate number of consecutive, common logic values. Clearly, the length register 16 may be eliminated if the convolutional coder register 12 is of a predetermined length, although such a structural limitation will affect the ability to alter or adapt the convolutional code function. Alternatively, the length register may be eliminated since the constraint length can be determined by the highest tap value for the polynomial function.

In addition to the convolutional coder register 12 and the length register 16, there is provided a plurality of tap (or generator) registers 20, 22 and 24 that are arranged to store a plurality of data bits that identify bit positions in the convolutional coder register 12 that are subject to logical operations (e.g. exclusive-OR (XOR)) during execution of the cyclic convolution code function. In this specific instance, there are three such tap registers 20, 22 and 24, although it will be appreciated that this number may be varied upwards from two such tap registers, subject to the requirements of the convolutional code function.

By way of example, bits 0, 2, 3, 5 and 6 have been identified (through the assignment of a logical "1,, to each respective bit) as requiring tapping to provide a first polynomial output g0 (in the polynomial sequence) from the logic network 11. Similarly, tap registers 24 and 22 contain data words that identify the particular bits of interest in the convolutional coder register 12 to provide the second and third polynomial outputs (g1 and g2, respectively) for use in producing the convolutional code 14. Again, like the length register 16, the tap registers 20, 22 and 24 are programmable to allow the tap positions to be re-defined at any time. Indeed, this re-programming may be implemented in real-time so that equipment can be adapted to receive a particular identified format of convolutional code. In the preferred embodiment and as will be appreciated, loading of a particular tap register with all logical "0"s will result in a polynomial output of zero, thus presenting a way of negating that particular polynomial output.

By logically combining (ANDing) corresponding bits of the length register and the taps registers (20, 22 and 24), bits in the convolutional coder register 12 are identified as requiring a logical operation to be performed thereon. More specifically, FIG. 3 illustrates the logical ANDing together of respective bits of tap registers 20 and 24 with convolutional coder register 12. For the sake of clarity, only eight AND gates (30-38) have been shown to illustrate the masking of each bit of the convolutional coder register 12 to produce each polynomial output (in this case g0 and g2), although it will be appreciated that such logical coupling is required between the corresponding bits. Alternatively, logical ANDing of corresponding bits of the tap registers with the convolutional coder register 12 may be substituted by a switch function defined by a logical "1" appearing in relevant bits of the tap registers 20-24. In this case, the logical "1" would allow a corresponding bit stored in convolutional coder register 12 to be passed forward, whereas a logical "0" would cause the switch function to open and thereby reject (or terminate) the bit.

Referring back specifically to FIG. 1, input data is applied to a most significant bit of convolutional coder register 12. Typically, the input data is first stored in an input register 17 and then sequentially entered into the convolutional coder register 12. However, it will be appreciated that the input data may be distributed across a block of memory whereby a data bit counter and a memory pointer are employed to successively load the input data into the convolutional coder register 12. In successive clock cycles, the input data is shifted along the length of the convolutional coder register 12 towards the least significant bit.

To generate the first polynomial output g0, bits D0, D2, D3, D5 and D6 of convolutional coder register 12 are masked by corresponding bits in tap register 20 to produce selected data taps. Data taps emanating from bits D2, D3, D5 and D6 are applied to first inputs of XOR gates 42, 44, 46 and 48. An output from each of XOR gates 42-46 is coupled to a second input of the next adjacent XOR gate, such as to produce a series arrangement of XOR gates. The output from XOR gate 48 provides the first polynomial output g0. Furthermore, in addition to being shifted into the most significant bit (D0), the input data also provides a second input to exclusive-OR (XOR) gate 42 coupled to receive the third most significant bit (D2) from convolutional coder register 12.

To generate the second polynomial output g1, bits D0, D1, D4 and D6 of convolutional coder register 12 are masked by corresponding bits in tap register 24 to produce selected data taps. Data taps emanating from bits D1, D4 and D6 are applied to first inputs of XOR gates 50, 52 and 54. An output from each of XOR gates 50 and 52 is coupled to a second input of the next adjacent XOR gate, such as to produce a series arrangement of XOR gates. The output from XOR gate 54 provides the second polynomial output g1.

Furthermore, in addition to being shifted into the most significant bit (D0), the input data also provides a second input to exclusive-OR (XOR) gate 50 coupled to receive the second most significant bit (D1) from convolutional coder register 12.

To generate the third polynomial output g2, bits D0, D1, D2, D3, D4 and D6 of convolutional coder register 12 are masked by corresponding bits in tap register 22 to produce selected data taps. Data taps D1, D2, D3, D4 and D6 are applied to first inputs of XOR gates 56, 58, 60, 62 and 64. An output from each of XOR gates 56-62 is coupled to a second input of the next adjacent XOR gate, such as to produce a series arrangement of XOR gates. The output from XOR gate 64 provides the third polynomial output g2. Furthermore, in addition to being shifted into the most significant bit D0, the input data also provides a second input to exclusive-OR (XOR) gate 56 coupled to receive the second most significant bit (D1) from convolutional coder register 12.

XOR logic gates 42-64 are included in logic network 11.

It will be appreciated that, in this example, the most significant bit D0 provided from the input register 17 always forms part of the polynomial outputs g0-g3. Therefore, although the input data will be sequenced through numerous storage elements of the convolutional coder 10 in successive clock cycles, a dedicated storage element for bit D0 need not be provided because the input can be applied directly to the various identified XOR gates. As such, the convolutional coder may be reduced in length (or the length register altered appropriately).

In a preferred embodiment, the polynomial outputs g0-g2 may be selected (either consecutively or in some other sequence) to provide the necessary "rate".

It will be appreciated that convolutional coding may require other forms of logic gates, such as OR gates, and that these may be appropriately combined or substituted in the logic network required by the present convolution coder.

In general, the number of processing steps required in a DSP to implement a convolutional coding function has been reduced by providing dedicated peripheral registers that identify tap positions (from a shift register, i.e. the convolutional coder register 12) required in a coding path. Subsequently, the logical combination of corresponding bits of the registers produces a result that can be input directly into a processing unit to produce a desired function in one processing step. This is illustrated in FIG. 4, in which a processor 70, such as an arithmetic logic unit (ALU), is coupled to a block of peripherals registers containing length and tap registers, with the ALU 70 arranged to perform a one-step operation to produce the desired convolutional code.

According to the present invention, tasks that require extensive processor activity (i.e. tasks that require multi-step instructions) have been replaced, where possible, by a hardware solution in which the number of processor steps required to execute a particular task has been reduced to a minimum. Consequently, the processor (such as a DSP) has a perceptual increase in processing power (capacity). Since previous multi-step tasks are now performed in a single instruction, there is a reduction in the time necessary to perform the task and therefore an increase in the number of such tasks that can be performed in unit time. As such, the throughput provided by each DSP is increased, thus allowing fewer DSPs to handle more voice communications in a base station of a communication system, for example.

Not only does the present invention provide the flexibility that allows adaptation of infrastructure equipment in which the present invention is installed, but there is a relative saving in cost over the prior art solution of developing dedicated, integrated circuits. Accordingly, the numerous aspects of the present invention provide a processing methodology and structure that is efficient (in as much as it requires only one step to be implemented in a DSP, for example) and flexible.

As will be appreciated, the concepts of the present invention are applicable to any equipment that utilises DSPs for ceding or the like, such equipment including subscriber handsets, O&Ms (Operation and Maintenance) infrastructure and Base Stations.

## Claims

1. A convolutional coder for generating a convolutional code, the convolutional coder comprising a shift register having a plurality of storage elements each for storing a data bit and an input for shifting input data into the convolutional coder, the convolutional coder characterised by:

   first and second tap registers, each for storing a tap position indicator indicative of tap positions in the shift register that are subject to a logical operation; and
   a logic network, coupled to receive the input data and arranged to provide the logical operation, having first and second outputs for providing, respectively, first and second output data bits that form the convolutional code;

   wherein the first output data bit is generated in response to the input data and the logical combination of each data bit stored in each storage element identified by the first tap position indicator; and

   the second output data bit is generated in response to the input data and the logical combination of each data bit stored in each storage element identified by the second tap position indicator.

2. The convolutional coder of claim 1, further comprising:

   a length register for storing a length indicator, the length register being logically coupled to the shift register whereby the length indicator sets a length of the shift register corresponding to a length of the convolutional coder.

3. A convolutional coder of claim 1 or 2, further comprising:

   a third tap registers for storing a third tap position indicator indicative of tap positions in the shift register that are subject to a logical operation;

   and wherein the logic network further comprises a third output for providing a third output data bit for forming the convolutional code; the third output data bit generated in response to the input data and the logical combination of each data bit stored in each storage element identified by the third tap position indicator.

4. The convolutional coder of claim 1, 2 or 3, wherein the logic network comprises a plurality of exclusive-OR units.

5. The convolutional coder of claim 4, wherein a plurality of exclusive-OR units are arranged between the input and each of said first and second outputs.

6. The convolutional coder of claim 5, wherein the plurality of exclusive-OR units between the input and each of said first and second outputs are in series.

7. The convolutional coder of claim 4, 5 or 6, wherein the plurality of exclusive-OR units each have an input for receiving a bit stored in one storage element identified by the tap position indicator.

**FIG.1**

CONVOLUTIONAL CODER

**FIG.3**

**FIG.4**

EP 0 750 401 A2

# FIG.2

12

| 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 |
|---|---|---|---|---|---|---|---|---|---|---|---|---|---|---|---|---|---|---|---|---|---|---|---|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |

CONVOLUTIONAL CODER REGISTER

16

| 1 | 1 | 1 | 1 | 1 | 1 | 1 | 0 | 0 | 0 | 0 | 0 | 0 | 0 | 0 | 0 | 0 | 0 | 0 | 0 | 0 | 0 | 0 | 0 |
|---|---|---|---|---|---|---|---|---|---|---|---|---|---|---|---|---|---|---|---|---|---|---|---|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |

LENGTH REGISTER

20

| 1 | 0 | 1 | 1 | 0 | 1 | 1 | 0 | 0 | 0 | 0 | 0 | 0 | 0 | 0 | 0 | 0 | 0 | 0 | 0 | 0 | 0 | 0 | 0 |
|---|---|---|---|---|---|---|---|---|---|---|---|---|---|---|---|---|---|---|---|---|---|---|---|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |

GENERATOR REGISTER FOR g0

22

| 1 | 1 | 1 | 1 | 1 | 0 | 1 | 0 | 0 | 0 | 0 | 0 | 0 | 0 | 0 | 0 | 0 | 0 | 0 | 0 | 0 | 0 | 0 | 0 |
|---|---|---|---|---|---|---|---|---|---|---|---|---|---|---|---|---|---|---|---|---|---|---|---|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |

GENERATOR REGISTER FOR g2

24

| 1 | 1 | 0 | 0 | 1 | 0 | 1 | 0 | 0 | 0 | 0 | 0 | 0 | 0 | 0 | 0 | 0 | 0 | 0 | 0 | 0 | 0 | 0 | 0 |
|---|---|---|---|---|---|---|---|---|---|---|---|---|---|---|---|---|---|---|---|---|---|---|---|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |

GENERATOR REGISTER FOR g1